# EUROPEAN PATENT APPLICATION

(11) **EP 1 427 034 A2**
(43) Date of publication of application: **09.06.2004**
(21) Application number: 03078666.9
(22) Date of filing: 24.11.2003
(51) Int. Cl.: H01L 51/40, H01L 21/00, H01L 33/00

(54) **Apparatus and method for making a light-emitting display**

(30) Priority: 06.12.2002 US 313591
(71) Applicant: EASTMAN KODAK COMPANY, Rochester, New York 14650 (US)
(72) Inventor: Sadasivan, Sridhar c/o Eastman Kodak Company, Rochester New York 14650-2201 (US); Jaqannathan, Ramesh c/o Eastman Kodak Company, Rochester New York 14650-2201 (US); Jaqannathan, Seshadri c/o Eastman Kodak Company, Rochester New York 14650-2201 (US); Sunderrajan, Suresh c/o Eastman Kodak Company, Rochester New York 14650-2201 (US); Nelson, David J. c/o Eastman Kodak Company, Rochester New York 14650-2201 (US); Irvin, Glen C. c/o Eastman Kodak Company, Rochester New York 14650-2201 (US); Mehta, Rajesh V. c/o Eastman Kodak Company, Rochester New York 14650-2201 (US)
(74) Representative: Haile, Helen Cynthia

(57) **Abstract**

A method and an apparatus for making a light emitting display is provided. The apparatus (20) includes a discharge device (105) with an inlet and an outlet with the portion of the discharge device defining a delivery path. An actuating mechanism (104) is moveably positioned along the delivery path. A substrate retaining device (24) is positioned spaced apart from the outlet of the discharge device in the delivery path. The inlet of the discharge device is adapted to be connected to a pressurized source (102a; 102b; 102c; 102d) of a thermodynamically stable mixture of a compressed fluid and one of a hole transporting material, a light emitting material, and an electron transporting material. The compressed fluid is in a gaseous state at a location beyond the outlet of the discharge device and prior to the substrate retaining device.

## Description

This invention relates generally to a method of making a light-emitting display and, more specifically, it relates to a method of making an organic light emitting display.

Organic Light emitting display (OLED) devices can be classified as either organic small molecule type or polymeric type based on the nature of electroluminescent material used to create the device. In simplest form, an OLED device is comprised of an anode for hole injection, a cathode for electron injection, and an organic medium sandwiched between these electrodes to support charge recombination that yields emission of light. A simple PLED device can be constructed from an electroluminescent polymeric layer sandwiched between an electron injection cathode and a hole injection anode. More complicated devices utilize electron and hole transport layers between the above mentioned electrode and the electroluminescent layers.

Common OLED devices include very simple structures comprising a single anode and cathode to more complex devices, such as passive and active matrix displays. A passive matrix display is comprised of orthogonal arrays of anodes and cathodes to form pixels at their intersections, wherein each pixel acts as an OLED device that can be electrically activated independently of other pixels. In active-matrix displays, an array of OLED devices (pixels) are formed in contact with thin film transistors (TFTs) such that each pixel is activated and controlled independently by these TFTs.

An electroluminescent device capable of producing full-color display is constructed with a plurality of light emitting pixels, which are generally arranged as an array in intersecting columns and rows. This is achieved by patterning the anode and cathode into a plurality of individually electrically addressable anode and cathode electrode devices which are orthogonally oriented with respect to each other, with an electroluminescent medium sandwiched between the plurality of anodes and plurality of intersecting cathodes, each section (pixel) thereby producing a light emitting diode when appropriately addressed. The aforementioned sandwiched electroluminescent medium can be fabricated by one of two basic designs:
(1) a display having the subpixel pattern of cathodes and anodes is fabricated as a monochrome light emitting display having a light emission in a blue spectral region, i.e., each sub-pixel is capable of emitting blue light when addressed by an electrical drive signal; and a color conversion medium oriented with respect to the subpixel capable of converting the blue light from a corresponding sub-pixel into one of red and green light, and capable of transmitting the blue light emitted by a corresponding subpixel. Such device architectures have been disclosed by Tang et al, in U.S. Patent No. 5,294,870.
(2) a display having a subpixel pattern of cathodes and anodes is fabricated along with light-emitting host material containing subpixels which are capable of emitting one of blue, red and green light directly when addressed by an electrical drive signal. The light- emitting host material containing subpixel is formed by doping the light-emitting host material with a florescent dopant selected to provide one of blue, red and green light directly. Such device architectures have been disclosed by Tang et al., in U.S. Patent No. 5,294,869. In scenarios where single color is needed the light-emitting host material containing subpixel does not include the florescent dopant.

In prior art multicolor fabrication systems, a masking operation is first performed to protect the areas that are not to receive an electroluminescent material. The electroluminescent material is then deposited using one of several techniques such as vacuum deposition, and casting and spin coating. The vacuum deposition process generally involves the evaporation of electroluminescent material by heating or by ion bombardment followed by deposition on the substrate by condensation or by a chemical reaction. An inherent limitation of the vacuum deposition process is that the electroluminescent material has to be thermally stable or has to have a thermally stable precursor that can generate the desired material on the substrate by a chemical reaction. This limits the choice of electroluminescent materials that can be used to create display devices.

After deposition of the electroluminescent material, the mask is removed and the mask for the next material layer is placed and the material is deposited. Such techniques are well known in art as shadow masking techniques. Each masking operation increases the cost of fabricating display devices and decreases the device yield. Hence it is advantageous to use methods that do not involve masking.

In U.S. Patent No. 5,972,419, Roitman et al. disclose an inkjet printing method for making a polymer based electroluminescent device. The electroluminescent polymer containing dopants to produce one of three red, green and blue pixel is dissolved in xylene to form ink. The ink is then dispensed through an inkjet print head at desired locations to make the device. A major limitation of this technology is that the non-aqueous liquids/solvents used to formulate the ink can be hazardous to health and the disposal of which can be prohibitively expensive.

To eliminate the need for potentially harmful solvents, it is possible to use environmental and health-benign supercritical or dense-phase fluids such as carbon dioxide as solvents. Technologies that use supercritical fluid solvents to create thin films are also known. For example, R.D. Smith in U.S. Patent 4,734,227, discloses a method of depositing solid films or creating fine powders through the dissolution of a solid material into a supercritical fluid solution and then rapidly expanding the solution to create particles of the marking material in the form of fine powders or long thin fibers, which may be used to make films. There is a problem with this method in that the free-jet expansion of the supercritical fluid solution results in a non-collimated/defocused spray that cannot be used to create high-resolution patterns directly on a receiver. Further, defocusing leads to losses of the marking material.

Other technologies that deposit a material onto a receiver using gaseous propellants are known. For example, Peeters et al., in U.S. Pat. No. 6,116,718, discloses a print head for use in a marking apparatus in which a propellant gas is passed through a channel, the marking material is introduced controllably into the propellant stream to form a ballistic aerosol for propelling non-colloidal, solid or semi-solid particulate or a liquid, toward a receiver with sufficient kinetic energy to fuse the marking material to the receiver. There is a problem with this technology in that the marking material and propellant stream are two different entities and the propellant is used to impart kinetic energy to the marking material. When the marking material is added into the propellant stream in the channel, a non-colloidal ballistic aerosol is formed prior to exiting the print head. This non-colloidal ballistic aerosol, which is a combination of the marking material and the propellant, is not thermodynamically stable/metastable. As such, the marking material is prone to settling in the propellant stream which, in turn, can cause marking material agglomeration, leading to discharge device obstruction and poor control over marking material deposition.

Huck et al., in WO 02/45868 A2, disclose a method of creating a pattern on a surface of a wafer using compressed carbon dioxide. The method includes dissolving or suspending a material in a solvent phase containing compressed carbon dioxide, and depositing the solution or suspension onto the surface of the wafer, the evaporation of the solvent phase leaving a patterned deposit of the material. The wafer is prepatterned using lithography to provide the wafer with hydrophilic and hydrophobic areas. After deposition of the solution (or suspension) onto the wafer surface followed by the evaporation of the solvent phase, the material (a polymer) sticks to one of the hydrophobic and hydrophilic areas. The solution (or suspension) is deposited on the wafer surface either in the form of liquid drops or a feathered spray.

This method is disadvantaged because deposition using a feathered spray requires that the wafer surface be prepatterned prior to deposition. Hence, direct patterning of the wafer surface is not possible because of the diverging profile (feathered) of the spray. Additionally, a wafer surface that has not been prepatterned can not be patterned using this method. This method also requires time for drying so that the solvent phase of the liquid drops (or feathered spray) can evaporate. During the time associated with solvent phase evaporation, the solvent and the material can diffuse (for example, into the surface or along the surface) degrading the desired pattern.

As such, there is a need for a technology that permits high speed, accurate, and precise delivery of electroluminescent material to a receiver to create light emitting displays.

There is a further need for a method that permits the use of thermally unstable/labile materials that reduces the use of expensive, and environmentally and human health-hazardous solvents.

There is a further need for a method that reduces the need for post-deposition drying of the receiver in order to eliminate solvent.

There is a further need for a method that reduces series of masking operations needed to create a device.

There is a further need for a patterned deposition technique that is applicable for a wide range of electroluminescent materials and that is not limited by specific properties of the electroluminescent materials.

According to one feature of invention a method of making a light emitting display includes providing a substrate; providing a first addressing electrode on the substrate; controllably depositing an organic material over the first set of addressing electrodes, and providing a second addressing electrode over the organic material, wherein the organic material is deposited over the first addressing electrode by controllably delivering a mixture of a compressed fluid solvent and the organic material toward the first addressing electrode, the organic material becoming free of the compressed fluid solvent prior to reaching the first addressing electrode.

According to another feature of the invention the method of making a light emitting display includes providing a substrate and a first set of addressing electrodes on the substrate. A hole transporting layer is formed over the first set of addressing electrodes by controllably delivering the mixture of a compressed fluid solvent and a hole transporting material toward the substrate, the hole transporting material becoming free of the compressed fluid solvent prior to reaching the first set of addressing electrodes. A light emitting layer is formed over the hole transporting layer by controllably delivering the mixture of a compressed fluid solvent and a light emitting material toward the substrate, the light emitting material becoming free of the compressed fluid solvent prior to reaching the hole transporting layer. An electron transporting layer is formed over the light emitting layer by controllably delivering the mixture of a compressed fluid solvent and a electron transporting material toward the substrate, the electron transporting material becoming free of the compressed fluid solvent prior to reaching the light emitting layer. A second set of addressing electrodes is formed on the electron transporting layer.

According to another feature of the present invention an apparatus for making a light emitting display includes a discharge device with an inlet and an outlet. A portion of the discharge device defines a delivery path. An actuating mechanism is moveably positioned along the delivery path. A substrate retaining device is positioned spaced apart from the outlet of the discharge device in the delivery path. The inlet of the discharge device is adapted to be connected to a pressurized source of a thermodynamically stable/ metastable mixture of a compressed fluid and one of a hole transporting material, a light emitting material, and an electron transporting material. The compressed fluid is in a gaseous state at a location beyond the outlet of the discharge device and prior to the substrate retaining device.

In the detailed description of the preferred embodiments of the invention presented below, reference is made to the accompanying drawings, in which:
FIG. 1 shows a cross-section of an LED device;
FIGS. 2A-2C are schematic views of a first embodiment made in accordance with the present invention;
FIGS. 3A-4B are schematic views of a discharge device and actuating mechanism made in accordance with the present invention;
FIG. 5 is a schematic view of a second embodiment made in accordance with the present invention;
FIG. 6 is a schematic view of a third embodiment made in accordance with the present invention;
FIG. 7 is a schematic view of a fourth embodiment made in accordance with the present invention;
FIGS. 8A-8B is a schematic view of a fifth embodiment made in accordance with the present invention; and
FIG. 9 is a schematic view of a sixth embodiment made in accordance with the present invention.

The present description will be directed in particular to elements forming part of, or cooperating more directly with, apparatus in accordance with the present invention. It is to be understood that elements not specifically shown or described may take various forms well known to those skilled in the art. Additionally, materials identified as suitable for various facets of the invention, for example, marking materials, solvents, equipment, etc. are to be treated as exemplary, and are not intended to limit the scope of the invention in any manner.

### General device architecture

The present invention can be employed in most LED device configurations. These include very simple structures comprising a single anode and cathode to more complex devices, such as passive matrix displays comprised of orthogonal arrays of anodes and cathodes to form pixels, and active-matrix displays where each pixel is controlled independently, for example, with thin film transistors (TFTs).

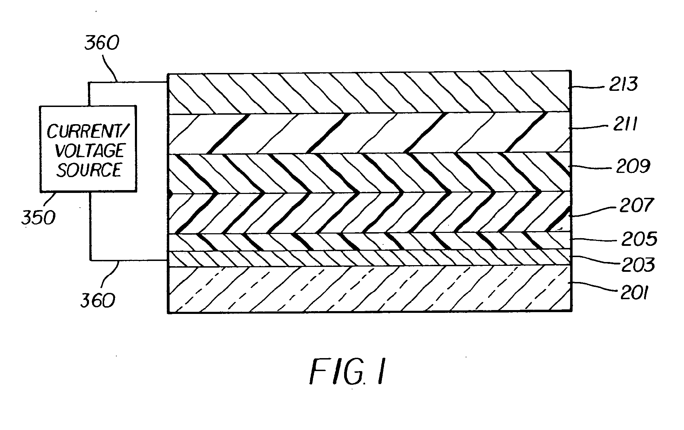

There are numerous configurations of the layers wherein the present invention can be successfully practiced. A typical structure is shown in FIG 1 and is comprised of a substrate 201, an anode 203, a hole-injecting layer 205, a hole-transporting layer 207, a light-emitting layer 209, an electron-transporting layer 211, and a cathode 213. These layers are described in detail below. Note that the substrate may alternatively be located adjacent to the cathode, or the substrate may actually constitute the anode or cathode. The electroluminescent layers between the anode and cathode are conveniently referred to as the organic EL element. The total combined thickness of the EL layers is preferably less than 500 nm.

The anode and cathode of the LED are connected to a voltage/current source 350 through electrical conductors 360. The LED is operated by applying a potential between the anode and cathode such that the anode is at a more positive potential than the cathode. Holes are injected into the organic EL element from the anode and electrons are injected into the organic EL element at the anode. Enhanced device stability can sometimes be achieved when the LED is operated in an AC mode where, for some time period in the cycle, the potential bias is reversed and no current flows. An example of an AC driven OLED is described in US 5,552,678.

### Substrate

The LED device of this invention is typically provided over a supporting substrate where either the cathode or anode can be in contact with the substrate. The electrode in contact with the substrate is conveniently referred to as the bottom electrode. Conventionally, the bottom electrode is the anode, but this invention is not limited to that configuration. The substrate can either be light transmissive or opaque, depending on the intended direction of light emission. The light transmissive property is desirable for viewing the EL emission through the substrate. Transparent glass or plastic is commonly employed in such cases. For applications where the EL emission is viewed through the top electrode, the transmissive characteristic of the bottom support is immaterial, and therefore can be light transmissive, light absorbing or light reflective. Substrates for use in this case include, but are not limited to, glass, plastic, semiconductor materials, silicon, ceramics, and circuit board materials. Of course it is necessary to provide in these device configurations a light-transparent top electrode.

### Anode

When EL emission is viewed through anode 203, the anode should be transparent or substantially transparent to the emission of interest. Common transparent anode materials used in this invention are indium-tin oxide (ITO), indium-zinc oxide (IZO) and tin oxide, but other metal oxides can work including, but not limited to, aluminum- or indium-doped zinc oxide, magnesium-indium oxide, and nickel-tungsten oxide. In addition to these oxides, metal nitrides, such as gallium nitride, and metal selenides, such as zinc selenide, and metal sulfides, such as zinc sulfide, can be used as the anode. For applications where EL emission is viewed only through the cathode electrode, the transmissive characteristics of anode are immaterial and any conductive material can be used, transparent, opaque or reflective. Example conductors for this application include, but are not limited to, gold, iridium, molybdenum, palladium, and platinum. Typical anode materials, transmissive or otherwise, have a work function of 4.1 eV or greater. Desired anode materials are commonly deposited by any suitable means such as evaporation, sputtering, chemical vapor deposition, or electrochemical means. Anodes can be patterned using well-known photolithographic processes. Optionally, anodes may be polished prior to application of other layers to reduce surface roughness so as to minimize shorts or enhance reflectivity.

### Hole-Injecting Layer (HIL)

While not always necessary, it is often useful to provide a hole-injecting layer 205 between anode 203 and hole-transporting layer 207. The hole-injecting material can serve to improve the film formation property of subsequent organic layers and to facilitate injection of holes into the hole-transporting layer. Suitable materials for use in the hole-injecting layer include, but are not limited to, porphyrinic compounds as described in US 4,720,432, plasma-deposited fluorocarbon polymers as described in US 6,127,004, US 6,208,075 and US 6,208,077, and some aromatic amines, for example, m-MTDATA (4,4',4"-tris[(3-methylphenyl)phenylamino]triphenylamine). Alternative hole-injecting materials reportedly useful in organic EL devices are described in EP 0 891 121 A1 and EP 1 029 909 A1.

### Hole-Transporting Layer (HTL)

The hole-transporting layer 207 contains at least one hole-transporting compound such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel et al. U.S. Patent No. 3,180,730. Other suitable triarylamines substituted with one or more vinyl radicals and/or comprising at least one active hydrogen containing group are disclosed by Brantley et al U.S. Patent Nos. 3,567,450 and 3,658,520.

A more preferred class of aromatic tertiary amines are those which include at least two aromatic tertiary amine moieties as described in U.S. Patent Nos. 4,720,432 and 5,061,569. The hole-transporting layer can be formed of a single or a mixture of aromatic tertiary amine compounds. Illustrative of useful aromatic tertiary amines are the following:
1,1-Bis(4-di-*p*-tolylaminophenyl)cyclohexane
1,1-Bis(4-di-*p*-tolylaminophenyl)-4-phenylcyclohexane
4,4'-Bis(diphenylamino)quadriphenyl
Bis(4-dimethylamino-2-methylphenyl)-phenylmethane
N,N,N-Tri(*p*-tolyl)amine
4-(di-p-tolylamino)-4'-[4(di-*p*-tolylamino)-styryl]stilbene
N,N,N',N'-Tetra-*p*-tolyl-4-4'-diaminobiphenyl
N,N,N',N'-Tetraphenyl-4,4'-diaminobiphenyl
N,N,N',N'-tetra-1-naphthyl-4,4'-diaminobiphenyl
N,N,N',N'-tetra-2-naphthyl-4,4'-diaminobiphenyl
N-Phenylcarbazole
4,4'-Bis[N-(1-naphthyl)-N-phenylamino]biphenyl
4,4'-Bis[N-(1-naphthyl)-N-(2-naphthyl)amino]biphenyl
4,4"-Bis[N-(1-naphthyl)-N-phenylamino]p-terphenyl
4,4'-Bis[N-(2-naphthyl)-N-phenylamino]biphenyl
4,4'-Bis[N-(3-acenaphthenyl)-N-phenylamino]biphenyl
1,5-Bis[N-(1-naphthyl)-N-phenylamino]naphthalene
4,4'-Bis[N-(9-anthryl)-N-phenylamino]biphenyl
4,4"-Bis[N-(1-anthryl)-N-phenylamino]-*p*-terphenyl
4,4'-Bis[N-(2-phenanthryl)-N-phenylamino]biphenyl
4,4'-Bis[N-(8-fluoranthenyl)-N-phenylamino]biphenyl
4,4'-Bis[N-(2-pyrenyl)-N-phenylamino]biphenyl
4,4'-Bis[N-(2-naphthacenyl)-N-phenylamino]biphenyl
4,4'-Bis[N-(2-perylenyl)-N-phenylamino]biphenyl
4,4'-Bis[N-( 1-coronenyl)-N-phenylamino]biphenyl
2,6-Bis(di-*p*-tolylamino)naphthalene
2,6-Bis[di-(1-naphthyl)amino]naphthalene
2,6-Bis[N-(1-naphthyl)-N-(2-naphthyl)amino]naphthalene
N,N,N',N'-Tetra(2-naphthyl)-4,4"-diamino-*p*-terphenyl
4,4'-Bis{N-phenyl-N-[4-(1-naphthyl)-phenyl]amino}biphenyl
4,4'-Bis[N-phenyl-N-(2-pyrenyl)amino]biphenyl
2,6-Bis[N,N-di(2-naphthyl)amine]fluorene
1,5-Bis[N-(1-naphthyl)-N-phenylamino]naphthalene
4,4',4"-tris[(3-methylphenyl)phenylamino]triphenylamine

Another class of useful hole-transporting materials includes polycyclic aromatic compounds as described in EP 1 009 041. Tertiary aromatic amines with more than two amine groups may be used including oligomeric materials. In addition, polymeric hole-transporting materials can be used such as poly(N-vinylcarbazole) (PVK), polythiophenes, polypyrrole, polyaniline, and copolymers such as poly(3,4-ethylenedioxythiophene) / poly(4-styrenesulfonate) also called PEDOT/PSS.

### Light-Emitting Layer (LEL)

As more fully described in U.S. Patent Nos. 4,769,292 and 5,935,721, the light-emitting layer (LEL) 209 of the organic EL element includes a luminescent or fluorescent material where electroluminescence is produced as a result of electron-hole pair recombination in this region. The light-emitting layer can be comprised of a single material, but more commonly consists of a host material doped with a guest compound or compounds where light emission comes primarily from the dopant and can be of any color. The host materials in the light-emitting layer can be an electron-transporting material, as defined below, a hole-transporting material, as defined above, or another material or combination of materials that support hole-electron recombination. The dopant is usually chosen from highly fluorescent dyes, but phosphorescent compounds, e.g., transition metal complexes as described in WO 98/55561, WO 00/18851, WO 00/57676, and WO 00/70655 are also useful. Dopants are typically coated as 0.01 to 10 % by weight into the host material. Polymeric materials such as polyfluorenes and polyvinylarylenes (e.g., poly(p-phenylenevinylene), PPV) can also be used as the host material. In this case, small molecule dopants can be molecularly dispersed into the polymeric host, or the dopant could be added by copolymerizing a minor constituent into the host polymer.

An important relationship for choosing a dye as a dopant is a comparison of the bandgap potential which is defined as the energy difference between the highest occupied molecular orbital and the lowest unoccupied molecular orbital of the molecule. For efficient energy transfer from the host to the dopant molecule, a necessary condition is that the band gap of the dopant is smaller than that of the host material. For phosphorescent emitters it is also important that the host triplet energy level of the host be high enough to enable energy transfer from host to dopant.

Host and emitting molecules known to be of use include, but are not limited to, those disclosed in U.S. Patent Nos. 4,768,292; 5,141,671; 5,150,006; 5,151,629; 5,405,709; 5,484,922; 5,593,788; 5,645,948; 5,683,823; 5,755,999; 5,928,802; 5,935,720; 5,935,721; and 6,020,078.

Metal complexes of 8-hydroxyquinoline (oxine) and similar derivatives constitute one class of useful host compounds capable of supporting electroluminescence. Illustrative of useful chelated oxinoid compounds are the following:
CO-1: Aluminum trisoxine [alias, tris(8-quinolinolato)aluminum(III)]
CO-2: Magnesium bisoxine [alias, bis(8-quinolinolato)magnesium(II)]
CO-3: Bis[benzo{f}-8-quinolinolato]zinc (II)
CO-4: Bis(2-methyl-8-quinolinolato)aluminum(III)-µ-oxo-bis(2-methyl-8-quinolinolato) aluminum(III)
CO-5: Indium trisoxine [alias, tris(8-quinolinolato)indium]
CO-6: Aluminum tris(5-methyloxine) [alias, tris(5-methyl-8-quinolinolato) aluminum(III)]
CO-7: Lithium oxine [alias, (8-quinolinolato)lithium(I)]
CO-8: Gallium oxine [alias, tris(8-quinolinolato)gallium(III)]
CO-9: Zirconium oxine [alias, tetra(8-quinolinolato)zirconium(IV)]

Other classes of useful host materials include, but are not limited to: derivatives of anthracene, such as 9,10-di-(2-naphthyl)anthracene and derivatives thereof as described in US 5,935,721, distyrylarylene derivatives as described in US 5,121,029, and benzazole derivatives, for example, 2, 2', 2"-(1,3,5-phenylene)tris[1-phenyl-1H-benzimidazole]. Carbazole derivatives are particularly useful hosts for phosphorescent emitters.

Useful fluorescent dopants include, but are not limited to, derivatives of anthracene, tetracene, xanthene, perylene, rubrene, coumarin, rhodamine, and quinacridone, dicyanomethylenepyran compounds, thiopyran compounds, polymethine compounds, pyrilium and thiapyrilium compounds, fluorene derivatives, periflanthene derivatives, indenoperylene derivatives, bis(azinyl)amine boron compounds, bis(azinyl)methane compounds, and carbostyryl compounds.

### Electron-Transporting Layer (ETL)

Preferred thin film-forming materials for use in forming the electron-transporting layer 211 of the organic EL elements of this invention are metal chelated oxinoid compounds, including chelates of oxine itself (also commonly referred to as 8-quinolinol or 8-hydroxyquinoline). Such compounds help to inject and transport electrons, exhibit high levels of performance, and are readily fabricated in the form of thin films. Exemplary oxinoid compounds were listed previously.

Other electron-transporting materials include various butadiene derivatives as disclosed in U.S. Patent No. 4,356,429 and various heterocyclic optical brighteners as described in U.S. Patent No. 4,539,507. Benzazoles and triazines are also useful electron-transporting materials.

### Cathode

When light emission is viewed solely through the anode, the cathode 213 used in this invention can be comprised of nearly any conductive material. Desirable materials have good film-forming properties to ensure good contact with the underlying organic layer, promote electron injection at low voltage, and have good stability. Useful cathode materials often contain a low work function metal (< 4.0 eV) or metal alloy. One preferred cathode material is comprised of a Mg:Ag alloy wherein the percentage of silver is in the range of 1 to 20 %, as described in U.S. Patent No. 4,885,221. Another suitable class of cathode materials includes bilayers comprising a thin electron-injection layer (EIL) in contact with the organic layer (e.g., ETL) which is capped with a thicker layer of a conductive metal. Here, the EIL preferably includes a low work function metal or metal salt, and if so, the thicker capping layer does not need to have a low work function. One such cathode is comprised of a thin layer of LiF followed by a thicker layer of A1 as described in U.S. Patent No. 5,677,572. Other useful cathode material sets include, but are not limited to, those disclosed in U.S. Patent Nos. 5,059,861; 5,059,862, and 6,140,763.

When light emission is viewed through the cathode, the cathode must be transparent or nearly transparent. For such applications, metals must be thin or one must use transparent conductive oxides, or a combination of these materials. Optically transparent cathodes have been described in more detail in US 4,885,211, US 5,247,190, JP 3,234,963, US 5,703,436, US 5,608,287, US 5,837,391, US 5,677,572, US 5,776,622, US 5,776,623, US 5,714,838, US 5,969,474, US 5,739,545, US 5,981,306, US 6,137,223, US 6,140,763, US 6,172,459, EP 1 076 368, US 6,278,236, and US 6,284,393. Cathode materials are typically deposited by evaporation, sputtering, or chemical vapor deposition. When needed, patterning can be achieved through many well known methods including, but not limited to, through-mask deposition, integral shadow masking, for example, as described in US 5,276,380 and EP 0 732 868, laser ablation, and selective chemical vapor deposition.

### Other Common Layers and Device Architecture

In some instances, layers 209 and 211 can optionally be collapsed into a single layer that serves the function of supporting both light emission and electron transportation. It also known in the art that emitting dopants may be added to the hole-transporting layer, which may serve as a host. Multiple dopants may be added to one or more layers in order to create a white-emitting OLED, for example, by combining blue- and yellow-emitting materials, cyan- and red- emitting materials, or red-, green-, and blue-emitting materials. White-emitting devices are described, for example, in EP 1 187 235, US 20020025419, EP 1 182 244, US 5,683,823, US 5,503,910, US 5,405,709, and US 5,283,182.

Additional layers such as electron or hole-blocking layers as taught in the art may be employed in devices of this invention. Hole-blocking layers are commonly used to improve efficiency of phosphorescent emitter devices, for example, as in US 20020015859.

This invention may be used in so-called stacked device architecture, for example, as taught in US 5,703,436 and US 6,337,492.

### Apparatus and method of making LED devices

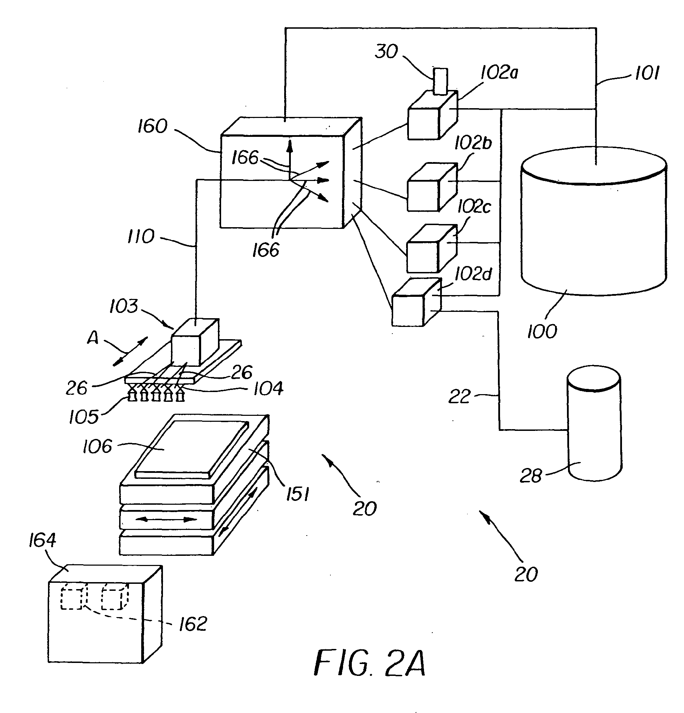

Referring to FIGS. 2A-2C, and 5-8B, an apparatus for making LED devices 20 is shown. The apparatus 20 includes a material delivery system 22 and a substrate retaining device 24. The material delivery system has a pressurized source of a thermodynamically stable mixture of a fluid and a material, herein after referred to as a formulation reservoir(s) 102a, 102b, 102c, 102d connected in fluid communication to a delivery path 26 at least partially formed in/on a printhead 103. The material in the material delivery system can be one of materials used to form a hole-injecting layer, hole-transporting layer, light-emitting layer, light-emitting layer containing dopants, and electron-transporting layer.

The printhead 103 includes a discharge device 105 positioned along the delivery path 26 configured (as discussed below) to produce a shaped beam of the marking material. An actuating mechanism 104 is also positioned along the delivery path 26 and is operable to control delivery of the material though the printhead 103.

The formulation reservoir(s) 102a, 102b, 102c, 102d is connected in fluid communication to a source of fluid 100 and a source of material 28 (shown with reference to formulation reservoir 102c in FIG. 2A). Alternatively, the material can be added to the formulation reservoir(s) 102a, 102b, 102c and 102d through a port 30 (shown with reference to formulation reservoir 102a in FIG. 2A).

One formulation reservoir 102a, 102b, 102c or 102d can be used when single layer device is desired. Alternatively, multiple formulation reservoirs 102a, 102b, 102c or 102d can be used when multiple layers devices are desired. When multiple formulation reservoirs 102a, 102b, 102c, 102d are used, each formulation reservoir 102a, 102b, 102c is connected in fluid communication through delivery path 26 to a discharge device(s) 105. A material selection device 160 is appropriately positioned along delivery path 26 such that each discharge device(s) 105 can selectively deliver material from each formulation reservoir 102a, 102b, 102c or 102d depending on the position of material selection device 160. Additionally, at least one inlet of the material selection device 160 is connected to the source of fluid 100.

One formulation reservoir 102a, 102b, 102c or 102d can be used when one of hole transporting layer, light emitting layer or electron transporting layer needs to be formed. Alternatively, multiple formulation reservoirs 102a, 102b, 102c or 102d can be used when all of hole tranporting layer, light emitting layer, electron transporting layer needs to be formed. If the electrode forming material is a conducting polymer, additional formulation reservoirs need to be provided to create bottom and top set of addressing electrodes.

A discussion of illustrative embodiments follows with like components being described using like reference symbols.

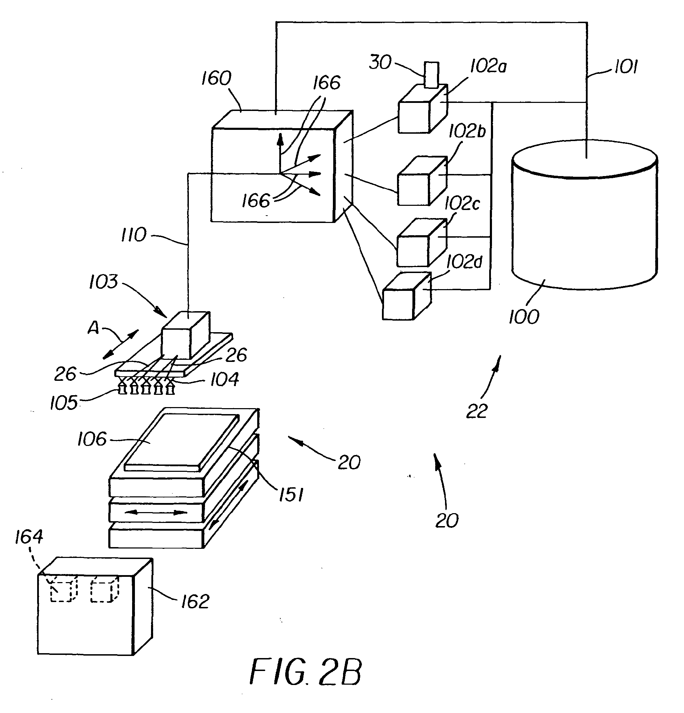

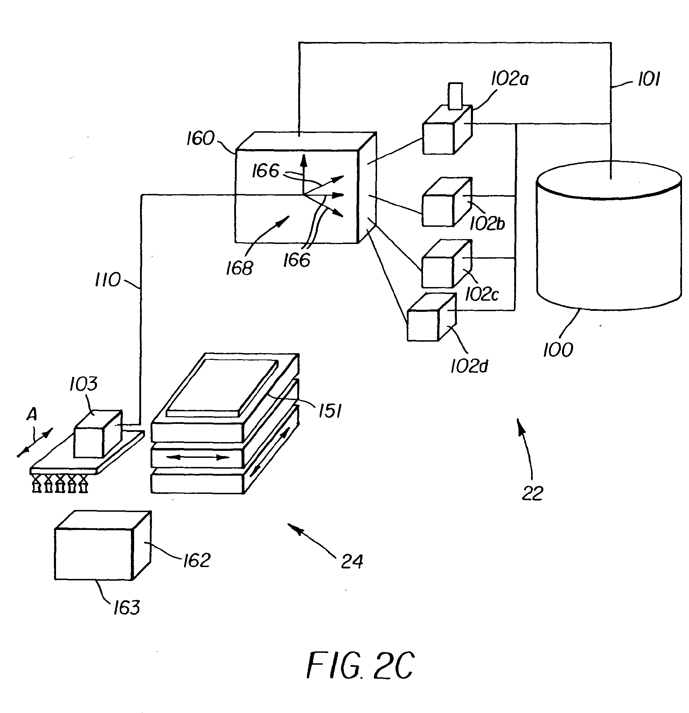

Referring to FIGS. 2A-2C, printhead 103, which includes at least one discharge device 105 and actuating mechanism 104 as described below with reference to FIGS. 2A-2B, is moveable (arrow A) between a first position where material is delivered on to the substrate (as shown in FIGS. 2A and 2B) and a second position where cleaning occurs (as shown in FIG. 2C). Printhead 103 translates in a first direction while substrate retaining device 24 translates in at least one other direction. The substrate retaining devices 24 can be a x,y,z translation device 151, rollers or individual receiver trays. Alternately, the substrate retaining device 24 can be a rotatable drum 150 that rotates in a second direction relative to printhead 103 during printing is shown in FIGS 2A-2C.

Printhead 103 is connected to material selection device 160 through flexible tubing 110 which allows printhead 103 to translate between the first position over substrate retaining device 24 and the second position over a cleaning station 162 and/or a calibrating station 163. Any suitable flexible tubing 110 can be used, for example, a Titeflex extra high-pressure hose P/N R157-3 (0.110 inside diameter, 4000 psi rated with a 2in bend radius) commercially available from Kord Industrial, Wixom, MI. In this embodiment, rigid tubing 101 connects material selection device 160 to formulation reservoir 102a, 102b, 102c, 102d and fluid source 100.

Alternatively, flexible tubing 110 can be replaced with rigid tubing 101 with appropriate modifications to the substrate retaining device 24 and the cleaning station 162. When rigid tubing 101 replaces flexible tubing 110, the substrate retaining device 24 should be able to translate in at least two directions during printing. This can be accomplished using, for example, x, y translation stages in any known manner. Alternatively, printhead 103 can be a page width type printhead with substrate retaining device 24 being moveable in at least one direction. Additionally, the cleaning station 162 can be modified such that cleaning station 162 can be positioned in the material delivery path of printhead 103. This can be accomplished using, for example, a solenoid mechanism that extends and retracts cleaning station 162 into and from the material delivery path.

The method of making a multilayer device involves delivering the material, which forms each layer of the device sequentially to the substrate. As such, each discharge device 105 of printhead 103 is used to eject each material. For example, material selection device 160 is positioned to allow a material (for example, a hole-injecting layer material) from formulation reservoir 102a to be ejected through discharge devices 105 on printhead 103. Printhead 103 and substrate retaining device 24 move together in one of the ways described above to deliver the material from formulation reservoir 102a onto a substrate 106. Actuating mechanism 104 is actuated in order to deliver the correct amount of material at the appropriate time and substrate location. When this process is complete, printhead 103 translates to cleaning station 162, as shown in FIG. 2C. Any hole-injecting layer material from formulation reservoir 102a remaining in line 110 is purged at the cleaning station 162 by positioning the material selection device 160 to allow fluid from source 100 to be ejected from discharge devices 105 and actuating mechanism 104. The above described process is then repeated in order to deliver hole-transporting layer material, light-emitting layer material and electron-transporting layer material from formulation reservoirs 102b, 102c and 102d.

Typically, the purging operation is performed for a predetermined amount of time and can be calculated using characteristics of the printing system 20 such as material mass flow rates, length of line 110, etc. Alternatively, a material sensing system 164 positioned in cleaning station 162 can be used to verify that the marking material from one formulation reservoir 102a, 102b, 102c, 102d has been removed from the line 110 prior to ejecting material from another of formulation reservoirs 102a, 102b, 102c and 102d.

When material sensing system 164 is used to determine whether material from one formulation reservoir 102a, 102b, 102c and 102d has been purged from line 110, a closed loop sensing operation is generally preferred. In this operation, purging continues until sensing system 164 indicates that an acceptable level of marking material remains in line 110. Sensing systems 164 of this type typically analyze ejected streams of material having individual particle sizes ranging from approximately 10 microns to approximately 100 microns and usually include a CCD sensor or camera with appropriate optics and a light source positioned away from the sensor or camera on the opposite side of the marking material stream. Suitable equipment for this type of marking material stream analysis is, for example, a Sony model #XC-75 camera, a Navitar Zoom lens P/N 60135, and a fiber-optic illuminator model A-3000 from Dolan Jenner.

In scenarios where only one of hole transporting layer, light emitting layer or electron transporting layer needs to be formed, the formulation reservoir containing the compressed fluid and one of hole transporting layer material, light emitting layer material or electron transporting layer material is connected in fluid communication with the print head 103 without the need for a material selection device 160. Alternately material selection device 160 can be used in such a situation with only one inlet from the formulation reservoir to the material selection device 160.

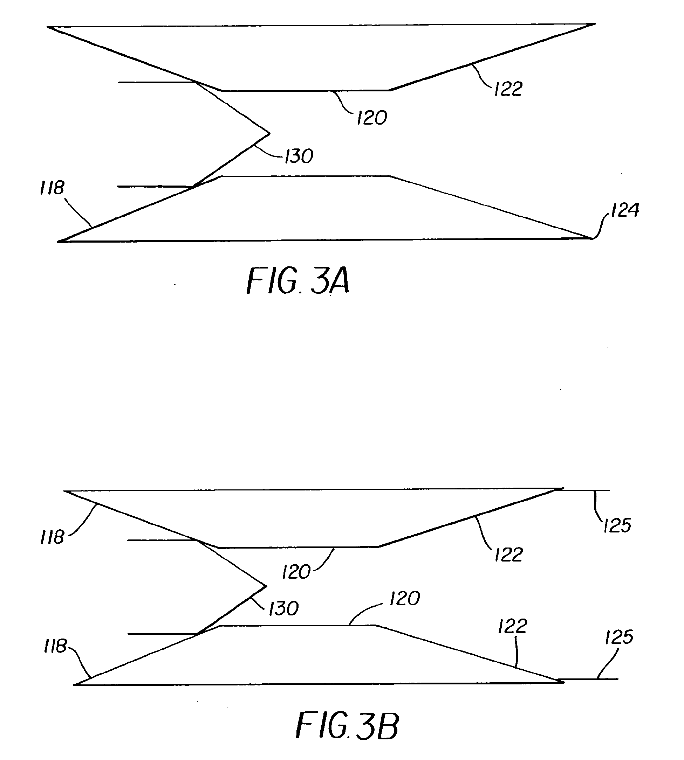

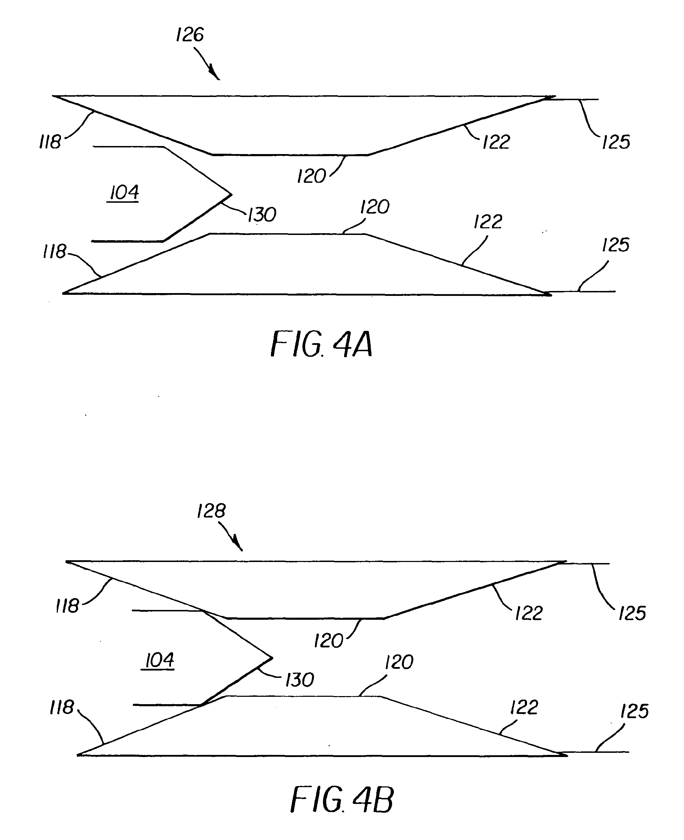

Referring to FIGS. 3A-4B, the discharge device 105 of the print head 103 includes a first variable area section 118 followed by a first constant area section 120. A second variable area section 122 diverges from constant area section 120 to an end 124 of discharge device 105. The first variable area section 118 converges to the first constant area section 120. The first constant area section 118 has a diameter substantially equivalent to the exit diameter of the first variable area section 120. Alternatively, discharge device 105 can also include a second constant area section 125 positioned after the variable area section 122. Second constant area section 125 has a diameter substantially equivalent to the exit diameter of the variable area section 122. Discharge devices 105 of this type are commercially available from Moog, East Aurora, New York; and Vindum Engineering Inc., San Ramon, California.

The actuating mechanism 104 is positioned within discharge device 105 and moveable between an open position 126 and a closed position 128 and has a sealing mechanism 130. In closed position 128, the sealing mechanism 130 in the actuating mechanism 104 contacts constant area section 120 preventing the discharge of the thermodynamically stable mixture of supercritical fluid and material. In open position 126, the thermodynamically stable mixture of supercritical fluid and material is permitted to exit discharge device 105.

The actuating mechanism 104 can also be positioned in various partially opened positions depending on the particular printing application, the amount of thermodynamically stable mixture of fluid and material desired, etc. Alternatively, actuating mechanism 104 can be a solenoid valve having an open and closed position. When actuating mechanism 104 is a solenoid valve, it is preferable to also include an additional position controllable actuating mechanism to control the mass flow rate of the thermodynamically stable mixture of fluid and material.

In a preferred embodiment of discharge device 105, the diameter of the first constant area section 120 of the discharge device 105 ranges from 20 microns to 2,000 microns. In a more preferred embodiment, the diameter of the first constant area section 120 of the discharge device 105 ranges from 10 microns to 20 microns. Additionally, first constant area section 120 has a predetermined length from 0.1 to 10 times the diameter of first constant area section 120 depending on the printing application. Sealing mechanism 130 can be conical in shape, disk shaped, etc.

Referring back to FIGS. 2A-2C, the marking material delivery system 22 takes a chosen solvent and/or predetermined materials to a compressed fluid, makes a solution and/or dispersion of a predetermined material or combination of materials in the chosen fluid, and delivers the marking materials as a collimated and/or focused beam onto a receiver 106 in a controlled manner. In a preferred application, the predetermined materials include hole-injecting layer material, hole-transporting layer material, light-emitting layer material and electron-transporting layer material.

In this context, the chosen materials taken to a compressed fluid state are gases at ambient pressure and temperature. Ambient conditions are preferably defined as temperature in the range from-100 to +100 °C, and pressure in the range from 1x10⁻⁸ - 1000 atm for this application.

A fluid carrier, contained in the fluid source 100, is any material that dissolves/solubilizes/disperses a material. The fluid source 100 delivers the fluid carrier at predetermined conditions of pressure, temperature, and flow rate as a compressed fluid. Materials that are above their critical point, as defined by a critical temperature and a critical pressure, are known as supercritical fluids. The critical temperature and critical pressure typically define a thermodynamic state in which a fluid or a material becomes supercritical and exhibits gas like and liquid like properties. Materials that are at sufficiently high temperatures and pressures below their critical point are known as compressed liquids. Materials that are at sufficiently high critical pressures and temperatures below their critical point are known as compressed gases. Materials in their supercritical fluid and/or compressed liquid/compressed gas state that exist as gases at ambient conditions find application here because of their unique ability to solubilize and/or disperse materials of interest when in their compressed fluid state.

Fluid carriers include, but are not limited to, carbon dioxide, nitrous oxide, ammonia, xenon, ethane, ethylene, propane, propylene, butane, isobutane, chlorotrifluoromethane, monofluoromethane, sulphur hexafluoride and mixtures thereof. In a preferred embodiment, carbon dioxide is generally preferred in many applications, due its characteristics, such as low cost, wide availability, etc.

The formulation reservoir(s) 102a, 102b, 102c and 102d in FIG. 2A is utilized to dissolve and/or disperse predetermined materials in compressed liquid/compressed gas or supercritical fluids with or without dispersants and/or surfactants, at desired formulation conditions of temperature, pressure, volume, and concentration. The combination of materials and compressed fluid is typically referred to as a mixture, formulation, etc.

The formulation reservoir(s) 102a, 102b, 102c and 102d in FIG. 2A can be made out of any suitable materials that can safely operate at the formulation conditions. An operating range from 0.001 atmosphere (1.013 x 10² Pa) to 1000 atmospheres (1.013 x 10⁸ Pa) in pressure and from -25 degrees Centigrade to 1000 degrees Centigrade is generally preferred. Typically, the preferred materials include various grades of high pressure stainless steel. However, it is possible to use other materials if the specific deposition or etching application dictates less extreme conditions of temperature and/or pressure.

The formulation reservoir(s) 102a, 102b, 102c and 102d in FIG. 2A should be adequately controlled with respect to the operating conditions (pressure, temperature, and volume). The solubility/dispersibility of materials depends upon the conditions within the formulation reservoir(s) 102a, 102b, 102c and 102d. As such, small changes in the operating conditions within the formulation reservoir(s) 102a, 102b, 102c and 102d can have undesired effects on material solubility/dispensability.

Additionally, any suitable surfactant and/or dispersant material that is capable of solubilizing/dispersing the materials in the compressed fluid for a specific application can be incorporated into the mixture of material and compressed fluid. Such materials include, but are not limited to, fluorinated polymers such as perfluoropolyether, siloxane compounds, etc.

The materials can be controllably introduced into the formulation reservoir(s) 102a, 102b, 102c and 102d. The compressed fluid is also controllably introduced into the formulation reservoir(s) 102a, 102b, 102c and 102d. The contents of the formulation reservoir(s) 102a, 102b, 102c and 102d are suitably mixed, using a mixing device to ensure intimate contact between the predetermined materials and compressed fluid. As the mixing process proceeds, materials are dissolved or dispersed within the compressed liquid/compressed gas/supercritical fluid. The process of dissolution/dispersion, including the amount of materials and the rate at which the mixing proceeds, depends upon the materials itself, the particle size and particle size distribution of the material (if the material is a solid), the compressed fluid used, the temperature, and the pressure within the formulation reservoir(s) 102a, 102b, 102c and 102d. When the mixing process is complete, the mixture or formulation of materials and compressed fluid is thermodynamically stable/metastable, in that the materials are dissolved or dispersed within the compressed fluid in such a fashion as to be indefinitely contained in the same state as long as the temperature and pressure within the formulation chamber are maintained constant. This state is distinguished from other physical mixtures in that there is no settling, precipitation, and/or agglomeration of material particles within the formulation chamber, unless the thermodynamic conditions of temperature and pressure within the reservoir are changed. As such, the material and compressed fluid mixtures or formulations of the present invention are said to be thermodynamically stable/metastable. This thermodynamically stable/metastable mixture or formulation is controllably released from the formulation reservoir(s) 102a, 102b, 102c and 102d through the discharge device 105 and actuating mechanism 104.

In the embodiment shown in FIGS. 2A-2C, material selection device 160 is a valve having four inputs 166 connected through rigid tubing 101 to formulation reservoirs 102a, 102b, 102c, 102d and fluid source 100. Additionally, material selection device 160 has one output 168 connected to printhead 103 through flexible tubing 110. Alternatively, material selection device 160 can include four individual two-position valves with the outputs of theses valves being connected through a plenum to flexible tubing 110. Suitable valves, for example, valves having a pressure rating of 3000 psi (model EH21 G7DCCM) are available from Peter Paul electronics, New Britain CT.

During the discharge process, the materials are precipitated from the compressed fluid as the temperature and/or pressure conditions change. The precipitated materials are preferably directed towards a receiver 106 by the discharge device 105 through the actuating mechanism 104 as a focussed and/or collimated beam. The invention can also be practiced with a divergent beam provided that the diameter of first constant area section 120 and printhead 103 to receiver 106 distance are appropriately small. For example, in a discharge device 105 having a 10um first constant area section 120 diameter, the beam can be allowed to diverge before impinging receiver 106 in order to produce a pixel size of required dimensions.

Discharge device 105 diameters of these sizes can be created with modern manufacturing techniques such as focused ion beam machining, MEMS processes, etc. Alternatively, capillary tubing made of PEEK, polyimide, etc. having a desired inner diameter (ca. 10 microns) and a desired outer diameter (ca. 15 microns) can be bundled together in order to form printhead 103 (for example, a rectangular array of capillaries in a 4 x 100, a 4 x 1000, or a 4 x 10000 matrix). Each capillary tube is connected to an actuating mechanism 104 thereby forming discharge device 105. Printing speed for a printhead formed in this fashion can be increased for a given actuating mechanism frequency by increasing the number of capillary tubes in each row.

The particle size of the materials deposited on the receiver 105 is typically in the range from 1 nanometer to 1000 nanometers. The particle size distribution may be controlled to be uniform by controlling the rate of change of temperature and/or pressure in the discharge device 105, the location of the receiver 106 relative to the discharge device 105, and the ambient conditions outside of the discharge device 105.

The print head 103 is also designed to appropriately change the temperature and pressure of the formulation to permit a controlled precipitation and/or aggregation of the materials. As the pressure is typically stepped down in stages, the formulation fluid flow is self-energized. Subsequent changes to the formulation conditions (a change in pressure, a change in temperature, etc.) result in the precipitation and/or aggregation of the material, coupled with an evaporation of the compressed fluid. The resulting precipitated and/or aggregated material deposits on the receiver 106 in a precise and accurate fashion. Evaporation of the supercritical fluid and/or compressed liquid/compressed gas can occur in a region located outside of the discharge device 105. Alternatively, evaporation of the compressed fluid can begin within the discharge device 105 and continue in the region located outside the discharge device 105. Alternatively, evaporation can occur within the discharge device 105.

A beam (stream, etc.) of the material and the compressed fluid is formed as the formulation moves through the discharge device 105. When the size of the precipitated and/or aggregated materials is substantially equal to an exit diameter of the discharge device 105, the precipitated and/or aggregated materials have been collimated by the discharge device 105. When the sizes of the precipitated and/or aggregated materials are less than the exit diameter of the discharge device 105, the precipitated and/or aggregated materials have been focused by the discharge device 105.

The substrate 106 is positioned along the path such that the precipitated and/or aggregated predetermined materials are deposited on the receiver 106. The distance of the receiver 106 from the discharge device 105 is chosen such that the compressed fluid evaporates to the gas phase prior to reaching the receiver 106. Hence, there is no need for a subsequent receiver drying processes. Alternatively, the receiver 106 can be electrically or electrostatically charged, such that the location of the material in the receiver 106 can be controlled.

It is also desirable to control the velocity with which individual particles of the marking material are ejected from the discharge device 105. As there is a sizable pressure drop from within the printhead 103 to the operating environment, the pressure differential converts the potential energy of the printhead 103 into kinetic energy that propels the material particles onto the receiver 106. The velocity of these particles can be controlled by suitable discharge device 105 with an actuating mechanism 104. Discharge device 105 design and location relative to the receiver 106 also determine the pattern of material deposition.

The temperature of the discharge device 105 can also be controlled. Discharge device temperature control may be controlled, as required, by specific applications to ensure that the opening in the discharge device 105 maintains the desired fluid flow characteristics.

The substrate 106 can be any solid material, including an organic, an inorganic, a metallo-organic, a metallic, an alloy, a ceramic, a synthetic and/or natural polymeric, a gel, a glass, or a composite material. Additionally, the substrate 106 can have more than one layer. The receiver 106 can be a sheet of predetermined size.

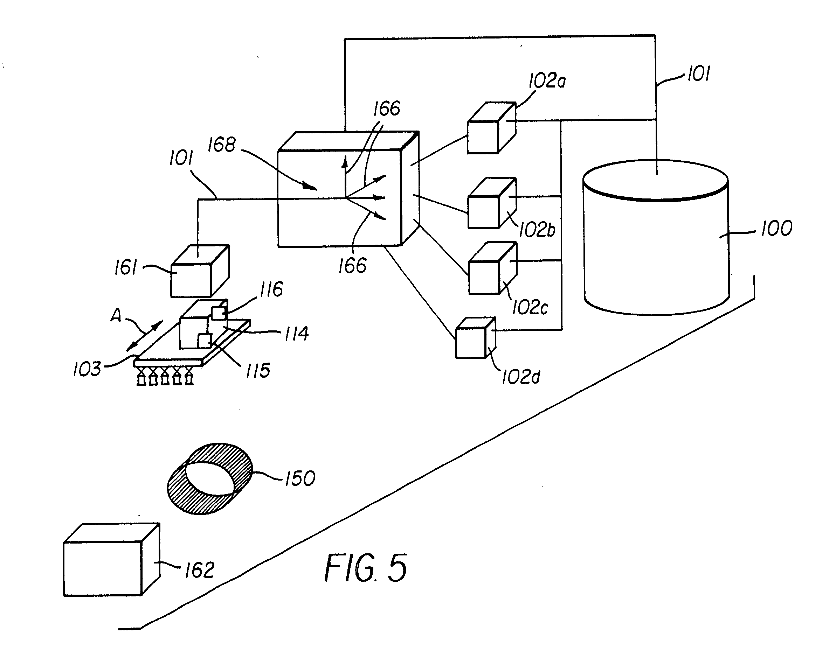

Referring to FIG. 5, an alternative embodiment is shown. An onboard reservoir 114 positioned on printhead 103 releasably mates with a docking station 161 connected to material selection device 160 through rigid tubing 101. Material selection device 160 is connected through rigid tubing 101 to fluid source 100 and formulation reservoirs 102a, 102b, 102c and 102d. Again, using material selection device 160 allows all discharge devices 105 to be used during each pass of the material delivery.

During operation, printhead 103 translates to docking station 161 and receives a quantity of material from one of formulation reservoirs 102a, 102b, 102c and 102d depending on the positioning of material selection device 160. The material is ejected onto substrate 106. Excess marking material, if any, is purged over cleaning station 162. The process is then repeated until materials for all layers are delivered.

Printhead 103 can translate back to docking station 161 (for example, to receive an additional quantity of fluid from fluid source 100) at any time during operation. This allows onboard reservoir 114 to be recharged as needed. For example, reservoir 114 can be recharged as a function of remaining pressure or weight of the formulation in reservoir 114, after a known volume of formulation has been ejected through printhead 103, after a predetermined number of translations over receiver 106, etc. Reservoir 114 is equipped with the appropriate known sensing mechanisms 116 in order to determine when reservoir 114 should be recharged.

Alternatively, reservoir 114 can be equipped with a pressure increasing device 115 that forces unused marking material and/or fluid back through docking station 161 and material selection device 160 and into the appropriate formulation reservoir 102a, 102b, 102c, 102d of fluid source 100 when the marking material and/or fluid is no longer needed. An example of a suitable pressure-increasing device 115 is a variable volume piston having a regulated fluid pressure source sufficient to force the material and/or fluid back through the marking material delivery system 22. Alternatively a mechanical force can be applied to the piston to force the material and/or fluid back through material delivery system 22.

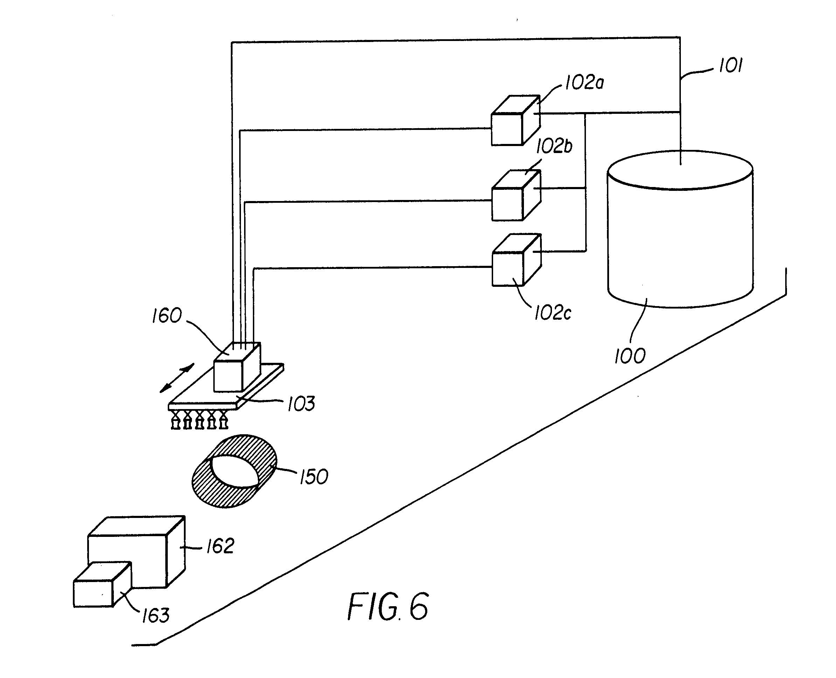

Referring to FIG. 6, another embodiment of the present invention is shown. In this embodiment, material selection device 160 is positioned on printhead 103 such that material selection device 160 and printhead 103 travel as a unit during operation. This embodiment helps to reduce waste and time associated with the cleaning process described above, for example when material selection device 160 is positioned to allow a different material to be ejected through printhead 103.

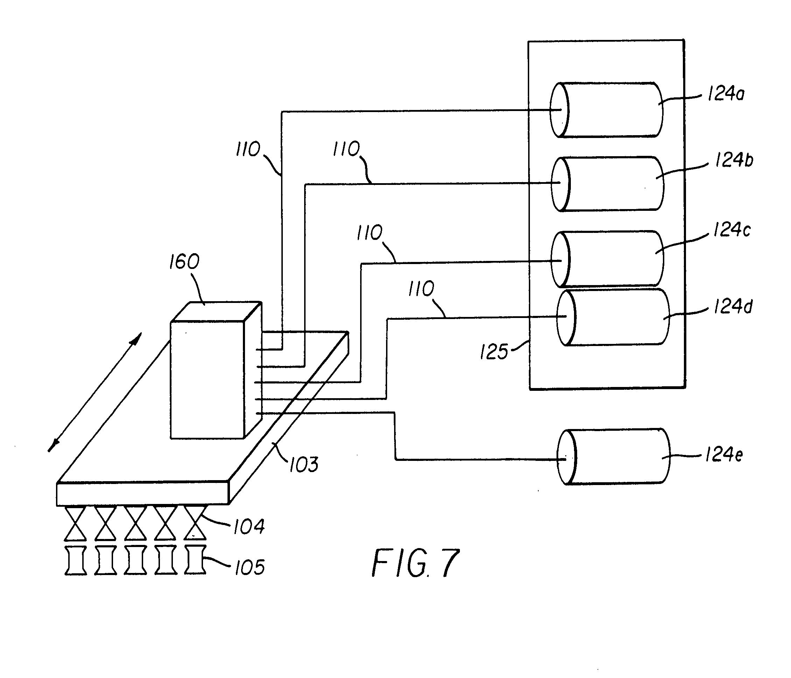

Referring to FIG.7, a premixed tank(s) 124a, 124b, 124c, containing premixed predetermined materials and the supercritical fluid and/or compressed liquid/compressed gas are connected in fluid communication through tubing 110 to printhead 103. Premixed tank 124e, containing fluid only, is also connected in fluid communication through tubing 110 to printhead 103. The premixed tank(s) 124a, 124b, 124c, 124d can be supplied and replaced either as a set 125, or independently in applications where the contents of one tank are likely to be consumed more quickly than the contents of other tanks. The size of the premixed tank(s) 124a, 124b, 124c, 124d can be varied depending on anticipated usage of the contents. The premixed tank(s) 124a, 124b, 124c, 124d are connected to the discharge devices 105 of printhead 103 through material selection device 160 positioned on printhead 103. When multi layer device fabrication is desired, each discharge device 105 can be utilized to eject a material from a particular premixed tank 124a, for example, and then utilized to eject a material from another premixed tank 124b, for example. Cleaning can be accomplished as described above.

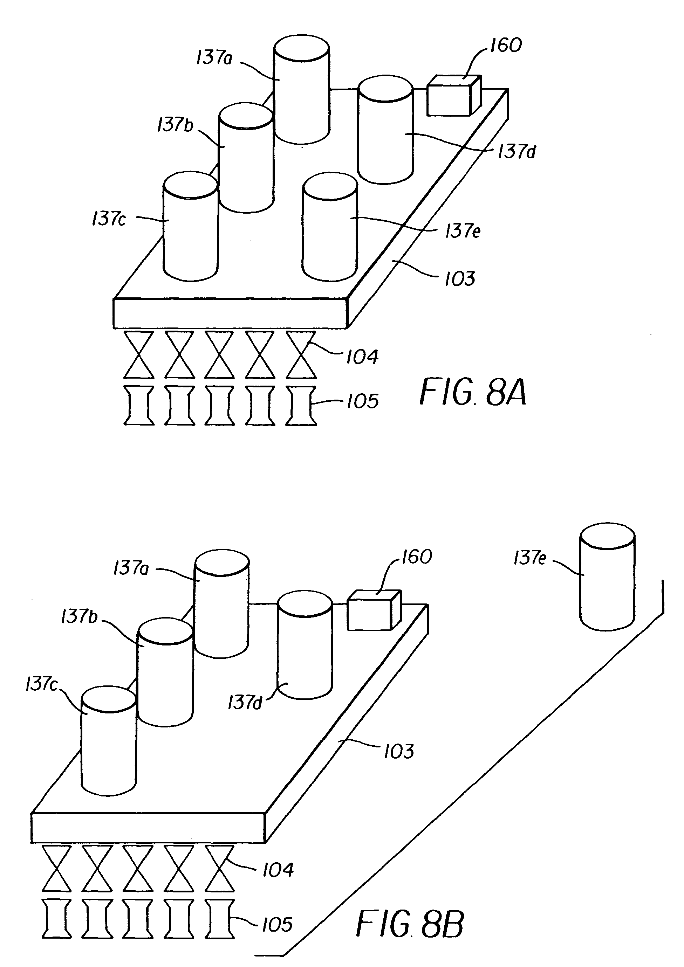

Referring to FIGS. 8A and 8B, another embodiment describing premixed canisters containing predetermined marking materials is shown. Premixed canister(s) 137a, 137b, 137c, 137d and 137e is positioned on the printhead 103. When replacement is necessary, premixed canister 137a, 137b, 137c, 137d and 137e can be removed from the printhead 103 and replaced with another premixed canister(s) 137a, 137b, 137c, 137d or 137e. Each of premixed canister(s) 137a, 137b, 137c, 137d is connected in fluid communication to discharge device 105 through material selection device 160. When multiple layer device fabrication is desired, each discharge device 105 can be utilized to eject a material from a particular premixed canister 137a, for example, and then utilized to eject a material from another premixed canister 137b, for example. Cleaning can be accomplished as described above.

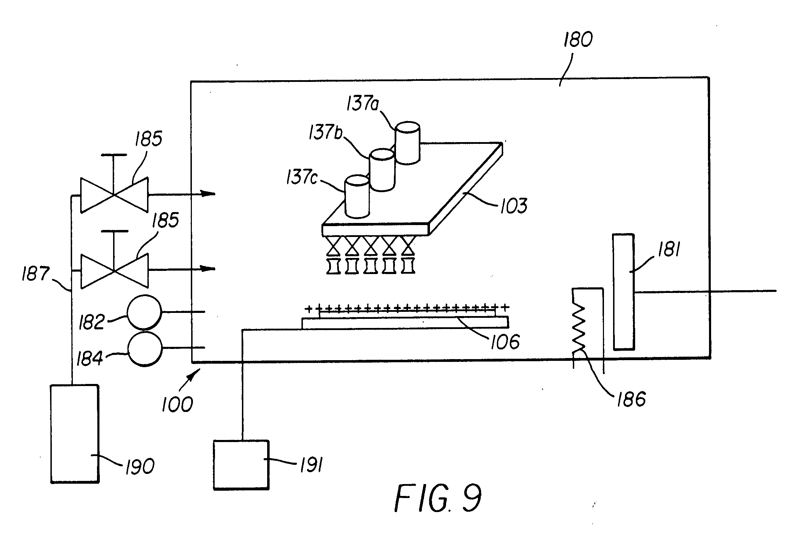

Referring to FIG. 9, an alternate embodiment is shown. The substrate 106, the cleaning station 162 and the printhead 103 are located within a deposition chamber 180. The deposition chamber 180 shown in FIG. 9 is designed for use at extremes of pressure. Incorporated in the chamber is a pressure modulator 181. The pressure modulator as shown resembles a piston. This is for illustration only. The pressure modulator could also be a pump, or a vent used in conjunction with an additional pressure source. An example of an additional pressure source is the compressed fluid source 190. This source is modulated with a flow control device 185 to enter the chamber via a delivery path 186. The pressure inside the chamber is carefully monitored by a pressure sensor 182. In addition, the chamber is provided with temperature sensor 184 and temperature modulator 186. Temperature modulator 186 is shown as an electric heater but could consist of any of the following: heater, a water jacket, a refrigeration coil, a combination of temperature control devices. The deposition chamber serves to hold the substrate 106 and facilitates the deposition of the material. To enable a more complete and even distribution of the material, electric or electrostatic charges can be used. Through the ejection process in the discharge assembly, the particles are known to become charged. Also shown are substrate charging device 191. Though in the figure, a positive charge is shown on the substrate. The polarity may be changed to suit the application. A charge opposite to that of the material to be delivered is applied to the substrate to attract the material.

Example methods of manufacturing a light emitting display will now be described. A first method begins with providing a substrate. A first addressing electrode is then created on the substrate. An organic material is controllably deposited over the first set of addressing electrodes by controllably delivering a mixture of a compressed fluid solvent and the organic material toward the first addressing electrode using the system described above. The organic material becomes free of the compressed fluid solvent prior to reaching the first addressing electrode (also described above). Then, a second addressing electrode is created over the organic material. The organic material is delivered towards the substrate in the form of a collimated beam or a focused beam as described above. The organic materials that are delivered towards the substrate can be organic small molecules or polymeric materials. The organic material that is delivered can be a light emitting material.

The organic material that is delivered can be a hole transporting material. If the organic material is a hole transporting material, the method involves controllably delivering a mixture of a compressed fluid solvent and the hole transporting material toward the first addressing electrode using the system described above. The light emitting material is then deposited on the hole transporting material by controllably delivering a mixture of a compressed fluid solvent and the light emitting material toward the hole transporting material using the system described above. Then, a second addressing electrode is created over the light emitting material to form the device.

The organic material that is delivered can be an electron transporting material. If the organic material is an electron transporting material, the method involves controllably delivering a mixture of a compressed fluid solvent and the light emitting material toward the first addressing electrode using the system described above. The electron transporting material is then deposited on the light emitting material by controllably delivering a mixture of a compressed fluid solvent and the electron transporting material toward the light emitting material using the system described above. Then, a second addressing electrode is created over the light emitting material to form the device. In another method, a hole transporting material is deposited by controllably delivering a mixture of a compressed fluid solvent and hole tranporting material toward the first addressing electrode. The light emitting material is then deposited by controllably delivering a mixture of a compressed fluid solvent and light emitting material toward the light emitting material toward the hole transporting material.

In yet another method, a plurality of first addressing electrodes is provided over the substrate and a plurality of second addressing electrode is also provided, the plurality of second addressing electrodes overlaps the plurality of first addressing electrodes to create a passive matrix display.

In yet another method, a plurality of first addressing electrodes is provided over the substrate and a single second addressing electrode is also provided, the single second addressing electrode overlaps the plurality of first addressing electrodes to create a active matrix display.

In yet another method, the electrode materials can be polymeric. In such a method, plurality of first addressing electrodes can be provided over the substrate by controllably delivering a mixture of a compressed fluid solvent and the first electrode material towards the substrate using the system described above. The second addressing electrodes are then provided over the organic material by controllably delivering a mixture of a compressed fluid solvent and the second electrode material towards the organic material using the system described above.

A second example method of manufacturing a light emitting display includes providing a substrate. A first set of addressing electrodes is created on the substrate. A hole transporting layer is created over the first set of addressing electrodes by controllably delivering the mixture of a compressed fluid solvent and a hole transporting material toward the substrate using the system described above. The hole transporting material becomes free of the compressed fluid solvent prior to reaching the first set of addressing electrodes (as described above). A light emitting layer is formed over the hole transporting layer by controllably delivering the mixture of a compressed fluid solvent and a light emitting material toward the substrate. The light emitting material becomes free of the compressed fluid solvent prior to reaching the hole transporting layer (as discussed above). An electron transporting layer is formed over the light emitting layer by controllably delivering the mixture of a compressed fluid solvent and a electron transporting material toward the substrate using the system described above. The electron transporting material becomes free of the compressed fluid solvent prior to reaching the light emitting layer, as discussed above. Finally, a second set of addressing electrodes is formed on the electron transporting layer.

In another method, a light emitting layer emits a monochrome light when energized. A color conversion medium oriented with respect to the light emitting material capable of converting the monochrome light from a corresponding light emitting material into one of red, green and blue light.

In yet another second method, depositing light emitting layer over the hole transporting layer includes controllably delivering the mixture of a compressed fluid solvent, the light emitting material, and a dopant material toward the substrate using the system described above. The mixture of the light emitting material and the dopant material becomes free of the compressed fluid solvent prior to reaching the hole transporting layer. The mixture of the light emitting material and the dopant material is patterned such that color subpixels are formed. In such a method the mixture of light emitting material and dopant material emit one of a red, green and blue light when energized.

The invention has been described in detail with particular reference to certain preferred embodiments thereof, but it will be understood that variations and modifications can be effected within the scope of the invention.

## Claims

1. A method of making a light emitting display comprising:
providing a substrate;
providing a first addressing electrode on the substrate;
controllably depositing an organic material over the first set of addressing electrodes, and
providing a second addressing electrode over the organic material, wherein the organic material is deposited over the first addressing electrode by controllably delivering a mixture of a compressed fluid solvent and the organic material toward the first addressing electrode, the organic material becoming free of the compressed fluid solvent prior to reaching the first addressing electrode.

2. The method according to Claim 1, wherein the organic material comprises organic small molecules.

3. The method according to Claim 1, wherein the organic material comprises polymeric materials.

4. The method according to Claim 1, wherein the organic material includes a light emitting material.

5. The method according to Claim 1, wherein the organic material includes a hole transporting material, the method further comprising:
controllably depositing a light emitting material over the hole transporting material prior to forming the second addressing electrode, wherein the light emitting material is deposited on the hole transporting material by controllably delivering a mixture of a compressed fluid solvent and the light emitting material toward the hole transporting material, the light emitting material becoming free of the compressed fluid solvent prior to reaching the hole transporting material.

6. The method according to Claim 5, further comprising:
controllably depositing an electron transporting material over the light emitting material prior to forming the second addressing electrode, wherein the electron transporting material is deposited on the light emitting material by controllably delivering a mixture of a compressed fluid solvent and the electron transporting material toward the light emitting material, the electron transporting material becoming free of the compressed fluid solvent prior to reaching the light emitting material.

7. The method according to Claim 1, wherein providing the first addressing electrode includes providing a plurality of first addressing electrodes and providing the second addressing electrode includes providing a plurality of second addressing electrodes, the plurality of second addressing electrodes overlapping the plurality of first addressing electrodes.

8. The method according to Claim 1, wherein providing the first addressing electrode includes providing a plurality of first addressing electrodes and providing the second addressing electrode includes providing a single second addressing electrode, the single second addressing electrode being common to the plurality of first addressing electrodes.

9. An apparatus (20) for making a light emitting display comprising:
a discharge device having an inlet and an outlet, a portion of the discharge device (105) defining a delivery path;
an actuating mechanism (104) moveably positioned along the delivery path; and
a substrate retaining device (24) positioned spaced apart from the outlet of the discharge device in the delivery path, the inlet of the discharge device being adapted to be connected to a pressurized source (102a; 102b; 102c; 102d) of a thermodynamically stable mixture of a compressed fluid and an organic material, the compressed fluid being in a gaseous state at a location beyond the outlet of the discharge device and prior to the substrate retaining device, the organic material being controllably directed toward the substrate retaining device.

10. The apparatus according to Claim 9, wherein the substrate retaining device and the outlet of the discharge device are located in a controlled environment.

11. The apparatus according to Claim 9, wherein the substrate retaining device, the discharge device, the actuating mechanism, and the material selection device is located in the controlled environment.

12. The apparatus according to Claim 9, further comprising:
a pressurized source of a thermodynamically stable mixture of the compressed fluid and the organic material connected in fluid communication with the inlet of the discharge device.

13. The apparatus according to Claim 9, the organic material including a hole transporting material, a light emitting material, and an electron transporting material, the apparatus further comprising:
a material selection device having a plurality of inlets and an outlet, the outlet of the material selection device being connected in fluid communication to the inlet of the discharge device; and
a plurality of pressurized sources of a thermodynamically stable mixture of a compressed fluid and one of the hole transporting material, the light emitting material, and the electron transporting material, each source being connected in fluid communication to one of the plurality of inlets of the material selection device.

14. The apparatus according to Claim 9, wherein the organic material is at least one of a hole transporting material, a light emitting material, and an electron transporting material.
